# EUROPÄISCHE PATENTANMELDUNG

(11) **EP 0 784 418 A2**
(43) Veröffentlichungstag der Anmeldung: **16.07.1997**
(21) Anmeldenummer: 97100120.1
(22) Anmeldetag: 07.01.1997
(51) Int. Cl.: H05K 3/00, H05K 3/28

(54) **Verfahren zur Herstellung von spritzgegossenen dreidimenssionalen Leiterformkörpern, sogenannten 3-D MID**

(30) Priorität: 15.01.1996 CH 104/96
(71) Anmelder: Fela Holding AG, 8512 Thundorf (CH)
(72) Erfinder: Uhlmann, Ernst, 9507 Stettfurt (CH)
(74) Vertreter: Petschner, Goetz

(57) **Zusammenfassung**

Beim Verfahren zur Herstellung eines spritzgegossenen dreidimensionalen Leiterformkörpers (3-D MID) in Form eines Gehäuseunterteiles (1) mit vollständig integrierter Elektronik (2) eines Strom-Messmoduls wird zunächst eine quasi plane Abwicklung des Leiterformkörpers in Form einer folienartigen, thermoplastischen Leiterplatte (3) hergestellt. Diese Leiterplattenfolie (3) kann in bekannter Weise metallisiert und dann im Siebdruck oder fotochemisch, insbesondere mittels Fotolithographie einseitig oder beidseitig strukturiert werden. Die metallisierte und strukturierte Leiterplattenfolie wird dann konventionell mit SMD-Komponenten (4), inklusive hier den Leuchtdioden (5) bestückt, wobei die SMD-Komponenten mittels Leitkleber oder Laserlöten elektrisch verbunden werden. Die Leiterplatte (3) wird dann hier an der Biegestelle (6) umgeformt und in das Spritzwerkzeug eingelegt oder im Spritzwerkzeug eingelegt und umgeformt und der dreidimensionale Leiterformkörper (1) durch An- und/oder Umspritzen mittels beispielsweise ABS-Kunststoff vervollständigt.

## Beschreibung

Die vorliegende Erfindung betrifft ein Verfahren zur Herstellung von spritzgegossenen dreidimensionalen Leiterformkörpern, sogenannten 3-D MID (Moulded Interconnection Devices).

Die Nutzung hochtemperaturtester Thermoplaste und deren strukturierte Metallisierung eröffnet der Elektronikindustrie eine neue Dimension für den Schaltungsaufbau, nämlich die räumlichen spritzgegossenen Schaltungsträger, die sogenannten 3-D Moulded Interconnection Devices (3-D MID).

Diese Fertigungsinnovation integriert elektrische und mechanische Elemente auf nahezu beliebig geformten Leiterkörpern, ermöglicht völlig neue Funktionen und hilft Produkte zu miniaturisieren. Durch die Einsparung mechanischer Bauteile wird die Montage vereinfacht und die Zuverlässigkeit erhöht. Der Einsatz thermoplastischer Kunststoffe zur Erzeugung von dreidimensionalen Schaltungsträgern eröffnet dabei der Elektronikbranche die Gestaltungsfreiheit der Spritzgußtechnik und ermöglicht durch das Zusammenfassen verschiedener Funktionen in einem dreidimensionalen Schaltungsträger die Verringerung der Teilezahl, die Verwirklichung besonderer Eigenschaften und damit eine Reduzierung der Montageschrifte. Damit können die Herstellungskette verkürzt, die Zuverlässigkeit erhöht und die Fertigungskosten gesenkt werden. Durch die Erschliessung neuer, bisher ungenutzter Prozeßflächen bietet die MID-Technik ein erhebliches Potential zur weiteren Miniaturisierung elektronischer Baugruppen.

Bei einem bereits bekannten Verfahren dieser Art wird ein Körper, der stromlos beschichtet werden kann, zuerst durch Spritzguß unter Verwendung von Kunstharz geformt, in das ein Beschichtungskatalysator eingemischt ist. Als zweites wird eine dünne Schicht, die nicht stromlos beschichtet werden kann, auf einer festgelegten Oberfläche des geformten Körpers durch einen weiteren Spritzgußvorgang geformt, wobei ein weiteres Kunstharz ohne Beschichtungskatalysator verwendet wird. Zuletzt wird der Körper mit Ausnahme der Schicht stromlos beschichtet. Ein leitfähiger Bereich wird dadurch auf der gewünschten Oberfläche des geformten Körpers gebildet.

Bei einem anderen bekannten Verfahren wird ein Körper zuerst unter Verwendung von Kunstharz geformt, das stromlos beschichtet werden kann. In der Folge wird ein Foto-Resist auf die Oberfläche des geformten Körpers aufgebracht, und ein Schaltungsmuster wird belichtet. Nachdem das Foto-Resist teilweise durch Entwickeln entfernt ist, wird die Oberfläche des geformten Körpers stromlos und/oder galvanisch beschichtet, wobei ein dreidimensionales Schaltungssubstrat gebildet wird.

Bei einem anderen bekannten Verfahren wird ein dreidimensionales Substrat geformt, und ein Schaltungsmuster wird auf die Oberfläche des dreidimensionalen Substrats unter Verwendung eines Übertragungsfilms übertragen.

Die Bildung eines leitfähigen Bereichs einschließlich eines Schaltungsmusters auf einer vorgegebenen Oberfläche eines dreidimensionalen Substrats durch Aufdampfen im Vakuum ist ebenfalls bereits vorgeschlagen worden.

Die vorstehend genannten Verfahren erfordern jedoch komplizierte Verfahrensschritte, wie das Spritzen der thermoplastischen Kunststoffteile, das nachfolgende Metallisieren dieser Kunststoffteile, dann ein Strukturieren der Metalloberfläche, das Layout, das Bestücken der strukturierten Kunststoffteile mit Bauteilen und das Verbinden der Bauteile mit der Metalloberfläche.

Ein dreidimensionales Substrat gemäss diesen bekannten Techniken ist daher schwierig herzustellen.

Es ist deshalb Aufgabe der vorliegenden Erfindung, ein Verfahren zur Herstellung von spritzgegossenen dreidimensionalen Leiterformkörpern der vorgenannten Art zu schaffen, durch das ein dreidimensionales Schaltungssubstrat, das ein beliebiges Schaltungsmuster und beliebige dreidimensionale From aufweist, leicht hergestellt werden kann.

Dies wird bei dem erfindungsgemässen Verfahren zur Herstellung von spritzgegossenen dreidimensionalen Leiterformkörpern (3-D MID) erfindungsgemäss dadurch erreicht, dass
a) eine quasi plane Abwicklung des Leiterformkörpers in Form einer folienartigen, thermoplastischen, metallisierten Leiterplatte hergestellt wird;
b) diese metallisierte Leiterplattenfolie im Siebdruck oder fotochemisch, insbesondere mittels Fotolithographie einseitig oder beidseitig strukturiert wird;
c) diese metallisierte und strukturierte Leiterplattenfolie konventionell mit SMD-Komponenten bestückt wird, wobei die SMD-Komponenten mittels Leitkleber oder Laserlöten elektrisch verbunden werden; und
d) die Leiterplatte dann umgeformt und in das Spritzwerkzeug eingelegt oder im Spritzwerkzeug eingelegt und umgeformt und der dreidimensionale Leiterformkörper durch An- und/oder Umspritzen vervollständigt wird.

Dieses erfindungsgemässe Verfahren arbeitet vergleichsweise den bisher bekannten Verfahren somit nach einem gänzlich anderen Prinzip.

Die Vorteile gegenüber der bisherigen Technik sind klar erkennbar, nämlich ein einfacheres Metallisieren des Thermoplastträgers, ein konventionelles Strukturieren auf einem zweidimensionalen Träger, eine SMD-Bestückung auf Standard-Bestückaufomaten sowie ein Integrieren der SMD-Komponenten im Leiterformkörper beim Umspritzen.

Ferner betrifft die vorliegende Erfindung einen spritzgegossenen dreidimensionalen Leiterformkörper (3-D MID), hergestellt nach dem erfindungsgemässen Verfahren.

Das erfindungsgemässe Verfahren wird nachfolgend anhand eines in den Zeichnungen dargestellten Ausführungsbeispiels näher erläutert. Es zeigen:
- Fig. 1: in schaubildartiger Darstellung eine mit SMD-Komponenten bestückte Leiterplattenfolie zur Verwendung in einem 3-D Leiterformkörper gemäss Fig 2 und
- Fig. 2: in schaubildartiger Darstellung einen erfindungsgemässen 3-D Leiterformkörper in Form eines Gehäuseunterteiles eines Strom-Messmoduls.

Beim Verfahren zur Herstellung eines spritzgegossenen dreidimensionalen Leiterformkörpers (3-D MID) in Form eines hier beispielsweise Gehäuseunterteiles 1 mit vollständig integrierter Elektronik 2 eines Strom-Messmoduls wird zunächst eine quasi plane Abwicklung des Leiterformkörpers in Form einer folienartigen, thermoplastischen Leiterplatte 3 von ca. 0,08mm bis 2,4mm, hier vorzugsweise 1,0mm Stärke, hergestellt. Diese Leiterplattenfolie 3 kann in bekannter Weise metallisiert und dann im Siebdruck oder fotochemisch, insbesondere mittels Fotolithographie einseitig oder beidseitig strukturiert werden. Die metallisierte und strukturierte Leiterplattenfolie wird dann konventionell, vorzugsweise auf einem herkömmlichen Bestückungsautomaten mit SMD-Komponenten 4, inklusive hier den Leuchtdioden 5 bestückt, wobei die SMD-Komponenten mittels Leitkleber oder Laserlöten elektrisch verbunden werden.

Die Leiterplatte 3 wird dann hier an der Biegestelle 6 umgeformt und in das Spritzwerkzeug (nicht gezeigt) eingelegt oder im Spritzwerkzeug eingelegt und umgeformt und der dreidimensionale Leiterformkörper 1 durch An- und/oder Umspritzen mittels beispielsweise ABS-Kunststoff vervollständigt.

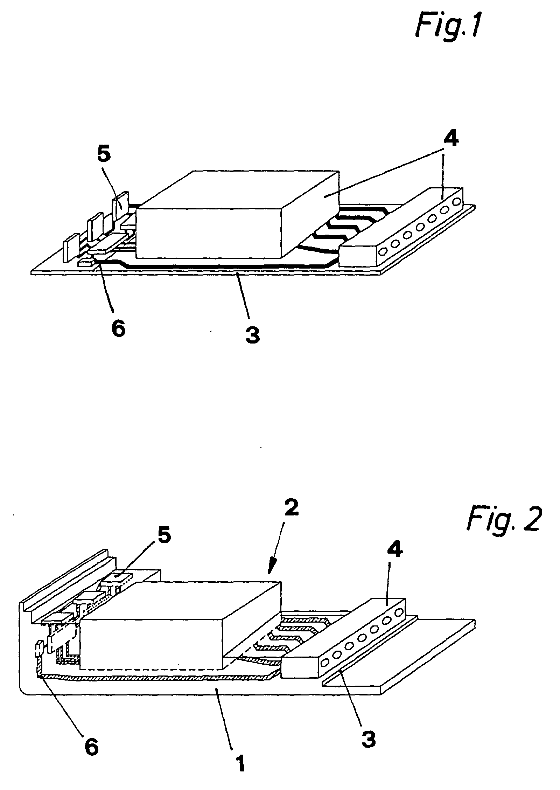

Wie Fig. 2 deutlich zeigt, sind die Leuchtdioden 5 nun nach oben weisend angeordnet und nur unterspritzt mit freier Leuchtfläche, wogegen die Leiterplattenfolie völlig im Leiterformkörper 1 integriert ist.

Durch dieses vorbeschriebene Verfahren ist nunmehr auf einfachste Weise die Herstellung von spritzgegossenen dreidimensionalen Leiterformkörpern möglich mit beliebigen Schaltungsmustern und beliebigen dreidimensionalen Formen.

Es wird Schutz beansprucht wie folgt:

## Patentansprüche

1. Verfahren zur Herstellung von spritzgegossenen dreidimensionalen Leiterformkörpern (3-D MID),
dadurch gekennzeichnet, dass
a) eine quasi plane Abwicklung des Leiterformkörpers in Form einer folienartigen, thermoplastischen, metallisierten Leiterplatte hergestellt wird;
b) diese metallisierte Leiterplattenfolie im Siebdruck oder fotochemisch, insbesondere mittels Fotolithographie einseitig oder beidseitig strukturiert wird;
c) diese metallisierte und strukturierte Leiterplattenfolie konventionell mit SMD-Komponenten bestückt wird, wobei die SMD-Komponenten mittels Leitkleber oder Laserlöten elektrisch verbunden werden; und
d) die Leiterplatte dann umgeformt und in das Spritzwerkzeug engelegt oder im Spritzwerkzeug eingelegt und umgeformt und der dreidimensionale Leiterformkörper durch An- und/oder Umspritzen vervollständigt wird.

2. Spritzgegossener dreidimensionaler Leiterformkörper (3-D MID), hergestellt nach dem Verfahren nach Patentanspruch 1.
